# EUROPEAN PATENT APPLICATION

(11) **EP 4 844 763 A1**
(43) Date of publication of application: **25.11.2026**
(21) Application number: 24919823.5
(22) Date of filing: 28.10.2024
(51) Int. Cl.: G11C 11/406

(54) **REFRESH CONTROL STRUCTURE, REFRESH CONTROL METHOD, AND MEMORY**

(30) Priority: 26.01.2024 CN 202410111236
(71) Applicant: CXMT Corporation, Hefei City, Anhui Province 230601 (CN)
(72) Inventor: DONG, Ping, Hefei, Anhui 230601 (CN); GU, Yinchuan, Hefei, Anhui 230601 (CN); LIU, Lu, Hefei, Anhui 230601 (CN)
(74) Representative: Gulde & Partner
(86) International application number: PCT/CN2024/127586
(87) International publication number: WO 2025/156743

(57) **Abstract**

The present disclosure relates to the field of semiconductor device structure design, and in particular, to a refresh control structure, a refresh control method, and a memory. The refresh control structure includes a processing circuit and a counter circuit. The processing circuit is configured to refresh a to-be-refreshed address based on a refresh window. The counter circuit is configured to generate the to-be-refreshed address, and control, based on a counter clock, the generated to-be-refreshed address to be incremented by 1. The counter circuit is further configured to reset a lowest bit of the to-be-refreshed address based on an abort signal, and in a process of resetting the lowest bit of the to-be-refreshed address, maintain a second lowest bit of the to-be-refreshed address unchanged. The present disclosure is configured to at least improve self refresh accuracy of the memory.

## Description

This application claims priority to Chinese Patent Application No. 202410111236.6, filed with the China National Intellectual Property Administration on January 26, 2024 and entitled "REFRESH CONTROL STRUCTURE, REFRESH CONTROL METHOD, AND MEMORY", which is incorporated herein by reference in its entirety.

### TECHNICAL FIELD

The present disclosure relates to the field of semiconductor device structure design, and in particular, to a refresh control structure, a refresh control method, and a memory.

### BACKGROUND

Memories are memory components configured to store programs and various types of data information. The memories may be classified into volatile memory apparatuses and non-volatile memory apparatuses. For a dynamic random access memory (DRAM) among the volatile memory apparatuses, data is stored by charging or discharging capacitors in memory cells, and the stored data is lost when power is cut off. For the non-volatile memory apparatuses, stored data can be retained when power is cut off.

The volatile memory apparatuses are widely applied as primary memories of various devices, whereas the non-volatile memory apparatuses are widely applied to various electronic apparatuses such as computers and mobile apparatuses to store program code and/or data.

In a working process, both the volatile memories and the non-volatile memories ensure accuracy of stored data by constantly performing refresh operations. The accuracy of the stored data can be ensured to certain extent by ensuring accuracy of the refresh operations.

### SUMMARY

Embodiments of the present disclosure provide a refresh control structure, a refresh control method, and a memory, to at least improve self refresh accuracy of the memory.

An embodiment of the present disclosure provides a refresh control structure, which is disposed in a bank and includes a processing circuit and a counter circuit. The processing circuit is configured to refresh a to-be-refreshed address based on a refresh window. The counter circuit is configured to generate the to-be-refreshed address, and control, based on a counter clock, the generated to-be-refreshed address to be incremented by 1. The counter circuit is further configured to reset a lowest bit of the to-be-refreshed address based on an abort signal, and in a process of resetting the lowest bit of the to-be-refreshed address, maintain a second lowest bit of the to-be-refreshed address unchanged.

According to the refresh control structure provided in this embodiment, in the process in which the counter circuit resets the lowest bit of the to-be-refreshed address, the second lowest bit of the to-be-refreshed address remains unchanged. Incrementing the to-be-refreshed address by a carry signal is avoided in the process of resetting the lowest bit, thereby further avoiding a possible occurrence of a missing refresh problem on the memory.

In some embodiments, the to-be-refreshed address is an n-bit binary signal. The counter circuit includes n cascaded counter units, and each counter unit includes the following: a first clock terminal, configured to receive the counter clock; a second clock terminal, configured to receive a delayed clock, the delayed clock being a delayed signal of the counter clock; a reset control terminal, configured to receive a reset signal, the reset control terminal of the counter unit at the first stage being further configured to receive the abort signal; a first output terminal, configured to generate an address signal, n address signals generated by the n counter units constituting the to-be-refreshed address; and a second output terminal, connected to a control terminal of the counter unit at the next stage, and configured to generate a carry signal, a control terminal of the counter unit at the first stage receiving a high level. The counter unit is configured to toggle the address signal based on the delayed clock and toggle the carry signal based on the counter clock when a signal input by a control terminal is valid.

In some embodiments, the counter unit includes the following: a NAND logic circuit, a first input terminal being connected to the control terminal, and a second input terminal being configured to receive the delayed clock; a first flip-flop, an inverted-clock terminal being connected to an output terminal of the NAND logic circuit, an output terminal being connected to the first output terminal, and a reset terminal being connected to the reset control terminal; and a second flip-flop, a clock terminal being configured to receive the counter clock, an input terminal being connected to the output terminal of the first flip-flop, an inverted-output terminal being connected to an input terminal of the first flip-flop, and a set terminal being connected to the reset control terminal.

In some embodiments, the counter unit further includes an AND logic circuit, a first input terminal being connected to an output terminal of the second flip-flop, a second input terminal being connected to the control terminal, and an output terminal being connected to the second output terminal.

In some embodiments, the refresh control structure further includes a delay unit, configured to generate the delayed clock based on the counter clock.

In some embodiments, the delay unit includes the following: a NOT logic circuit, an input terminal being configured to receive the counter clock; a delay circuit, an input terminal being connected to an output terminal of the NOT logic circuit; and a NOR logic circuit, a first input terminal being configured to receive the counter clock, a second input terminal being connected to an output terminal of the delay circuit, and an output terminal being configured to output the delayed clock.

In some embodiments, the delay unit includes a delay circuit, an input terminal being configured to receive the counter clock, and an output terminal being configured to output the delayed clock.

In some embodiments, the counter circuit is configured to reset the to-be-refreshed address based on a reset signal.

Another embodiment of the present disclosure further provides a refresh control method, applied to a self refresh mode of a memory, including: a to-be-refreshed address is obtained, and the to-be-refreshed address is refreshed based on a refresh window; the to-be-refreshed address is controlled, based on a counter clock, to be incremented by 1 after the refresh is complete, an even number of refresh windows being opened based on the same refresh command; and the to-be-refreshed address is adjusted based on the refresh control structure provided based on the foregoing embodiments in a refresh execution process if an abort signal is received.

Still another embodiment of the present disclosure further provides a memory. The memory is provided with multiple banks, and each of the multiple banks includes the refresh control structure provided in the foregoing embodiments, and performs a self refresh function based on the refresh control structure.

### BRIEF DESCRIPTION OF DRAWINGS

One or more embodiments are exemplified with the figures in the accompanying drawings corresponding to the one or more embodiments. These example descriptions are not intended to limit the embodiments, and unless specifically stated, no scale limitations are constituted by the figures in the accompanying drawings. To describe the technical solutions in the embodiments of the present disclosure or the conventional technologies more clearly, the accompanying drawings required by the embodiments are briefly described below. Clearly, the accompanying drawings in the following description show merely some embodiments of the present disclosure, and other drawings may be obtained by a person of ordinary skill in the art from these accompanying drawings without creative efforts.
FIG. 1 shows correspondences between a refresh command and a refresh window of a memory in different refresh modes according to the present disclosure;
FIG. 2 is a schematic diagram of a principle of performing refresh address counting by a memory in a self refresh mode according to the present disclosure;
FIG. 3 is a schematic diagram of a principle of performing refresh address counting by a memory when the memory is in a self refresh mode and aborts a self refresh process according to the present disclosure;
FIG. 4 is a schematic structural diagram of a counter structure according to the present disclosure;
FIG. 5 is a schematic structural diagram of each counter unit in the counter structure shown in FIG. 4 according to the present disclosure;
FIG. 6 is a schematic diagram of a counting principle of the counter structure shown in FIG. 4 and FIG. 5 according to the present disclosure;
FIG. 7 is a schematic structural diagram of a refresh control structure according to an embodiment of the present disclosure;
FIG. 8 is a schematic structural diagram of a counter circuit according to an embodiment of the present disclosure;
FIG. 9 is a schematic structural diagram of each counter unit in the counter circuit shown in FIG. 8 according to an embodiment of the present disclosure; and
FIG. 10 is a schematic diagram of a counting principle of the counter circuit shown in FIG. 8 and FIG. 9 according to an embodiment of the present disclosure.

### DESCRIPTION OF EMBODIMENTS

According to BACKGROUND, in a working process, a memory ensures accuracy of stored data by constantly performing refresh operations. The accuracy of the stored data can be ensured to certain extent by ensuring accuracy of the refresh operations.

An embodiment of the present disclosure provides a refresh control structure, to at least improve self refresh accuracy of a memory.

A person of ordinary skill in the art may understand that in the embodiments of the present disclosure, many technical details are provided to enable readers to better understand the present disclosure. However, the technical solutions claimed in the present disclosure may be implemented even without these technical details and various variations and modifications made based on the following embodiments. The division of the following embodiments is for ease of description, and should not constitute any limitation on a specific implementation of the present disclosure. The embodiments may be mutually combined and mutually referenced when there is no contradiction.

The refresh control structure provided in this embodiment of the present disclosure is described in detail below with reference to the accompanying drawings. The details are as follows.

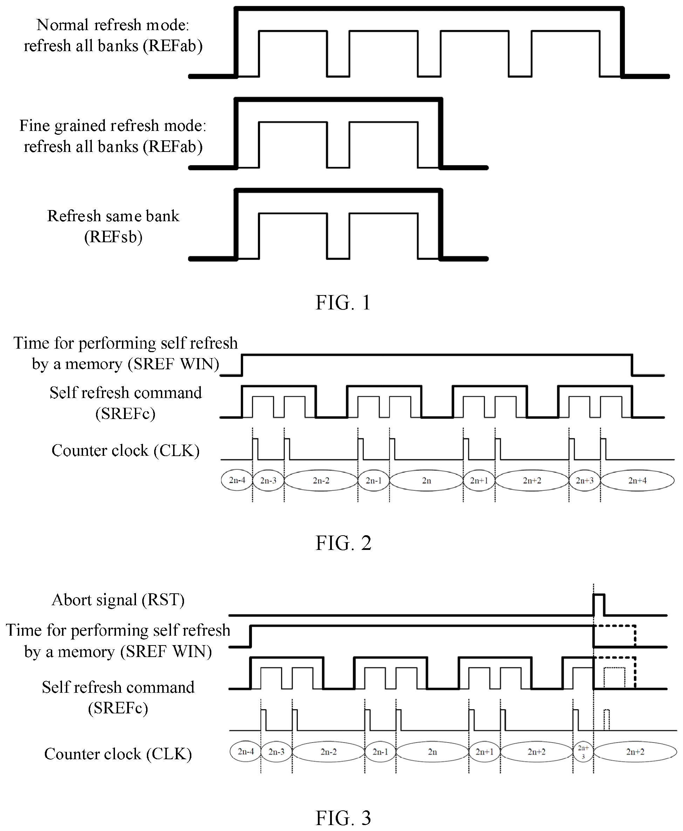

There are two types of refresh commands for a memory provided in this embodiment of the present disclosure: refresh all banks (REFab) and refresh same bank (REFsb). The REFab is intended to instruct all banks in the memory to refresh to-be-refreshed addresses. The REFsb is intended to instruct a target bank in the memory to refresh to-be-refreshed addresses. In addition, the number of refresh windows opened by a single REFab is greater than the number of refresh windows opened by a single REFsb. Referring to FIG. 1, FIG. 1 shows correspondences between a refresh command and a refresh window of a memory in different refresh modes according to the present disclosure. In an example, four refresh windows are opened by a single REFab, and two refresh windows are opened by a single REFsb. In another example, five refresh windows may be opened by a single REFab, and three refresh windows may be opened by a single REFsb.

In addition, the memory is provided with three refresh modes, which are respectively a normal refresh mode, a fine grained refresh (FGR) mode, and a self refresh (SREF) mode. The memory performs refresh based on the REFab in the normal refresh mode, and the memory also performs refresh based on the REFab in the FGR mode. However, the number of refresh windows opened by the REFab in the FGR mode is less than the number of refresh windows opened by the REFab in the normal refresh mode. The memory performs refresh based on the REFsb in the SREF mode. Referring to FIG. 1, in an example, four refresh windows are opened by a single REFab in the normal refresh mode, two refresh windows are opened by a single REFab in the FGR mode, and two refresh windows are opened by a single REFsb in the SREF mode. In another example, five refresh windows may be opened by a single REFab in the normal refresh mode, three refresh windows may be opened by a single REFab in the FGR mode, and three refresh windows may be opened by a single REFsb in the SREF mode.

For REFab, a refresh address counter is set in a storage controller, and a count of the refresh address counter is incremented by 1 based on a refresh window. For example, for the four refresh windows opened by a single REFab: in the first refresh window, a refresh address of the refresh address counter is n, and the refresh address n is refreshed by all the banks in the memory; in the second refresh window, a refresh address of the refresh address counter is n+1, and the refresh address n+1 is refreshed by all the banks in the memory; in the third refresh window, a refresh address of the refresh address counter is n+2, and the refresh address n+2 is refreshed by all the banks in the memory; and in the fourth refresh window, a refresh address of the refresh address counter is n+3, and the refresh address n+3 is refreshed by all the banks in the memory. For REFsb, a refresh address counter is set in each of a storage controller and all the banks. The first REFsb is intended to instruct the first bank to perform refresh. In the first refresh window, the first bank refreshes a refresh address n delivered by the refresh address counter in the storage controller, and then a count of the internal refresh address counter of the bank is incremented by 1 based on the refresh address n. In the second refresh window, the first bank refreshes a refresh address n+1 obtained by its internal refresh address counter. The second REFsb is intended to instruct the second bank to perform the foregoing refresh operation, until all the banks complete refreshing the refresh address n and the refresh address n+1. The refresh address in the refresh address counter in the storage controller is incremented by 2, so that with the next REFsb, the first bank starts to refresh a refresh address n+2.

It may be learned from the foregoing discussion that the number of refresh windows opened by a refresh command varies with a refresh mode, and a different number of refresh windows affects configuration of an internal refresh address counter of a bank. For example, if values of the internal refresh address counters of the banks include both odd and even values when a refresh command is ended, the refresh address counters can be configured only through a full adder in this case. A full adder has relatively large circuit area. If one full adder is disposed in each bank, a circuit area of the memory is greatly increased. If the numbers of refresh windows opened by different refresh commands are all set to even numbers, the values of the internal refresh address counters of the banks are definitely even numbers when any refresh command is ended. In this case, for the second refresh window opened by the REFsb, refresh can be implemented by inverting the lowest bit of the address. Compared with a circuit implemented with a full adder, inverting the lowest bit of the address only involves one inverter, and the circuit area of the memory can be greatly reduced.

In DDR specifications, after the memory exits the SREF, if a refresh action is being performed currently, the DRAM completes the entire refresh operation and proceeds to refresh a remaining row address. Because an activate operation and a precharge operation for a refresh operation are performed by all the banks simultaneously, required peak and average currents are very large. Such a large current demand easily causes disturbance to a power supply of the memory. However, locking of a delay phase-locked loop (delay PLL, DLL) is initiated by the storage controller by delivering an instruction to execute the SREF. Consequently, the locking of the DLL occurs in an environment with relatively large disturbance of the power supply of the memory.

Based on this problem, for the SREF of the memory, an SREF abort function needs to be implemented. When the SREF abort function is applied to exit the SREF, an ongoing refresh operation is aborted. However, abort of the ongoing refresh operation may cause an odd value of the internal refresh address counter of a bank after the SREF exit. If REFsb is performed in this case, an address refresh miss is caused. That is, for the SREF abort function, the internal refresh address counter of a bank needs to be reset to an even address.

Referring to FIG. 2, FIG. 2 is a schematic diagram of a principle of performing refresh address counting by a memory in a self refresh mode according to the present disclosure. In an ideal case, SREF WIN is intended to represent a time for performing the SREF by the memory. That is, in an example of FIG. 2, the memory performs the SREF when SREF WIN is valid. During the SREF, the memory refreshes a to-be-refreshed address based on a refresh window opened by a self refresh command SREFc, and generates a counter clock CLK accordingly each time a self refresh window is opened. The counter clock CLK is configured to count refresh addresses, and obtain a to-be-refreshed address that needs to be refreshed in the next self refresh window. As shown in FIG. 2, in a normal SREF process, the memory refreshes to-be-refreshed addresses 2n-4 to 2n+4 successively.

Referring to FIG. 3 in conjunction with FIG. 2, FIG. 3 is a schematic diagram of a principle of performing refresh address counting by a memory when the memory is in a self refresh mode and aborts a self refresh process according to the present disclosure. If the SREF abort function is performed during the SREF process of the memory, the SREF abort function is represented based on an abort signal RST in an example of FIG. 3. When the abort signal RST is at a high level, the SREF abort function is performed.

Specifically, the abort signal RST forcibly terminates the SREF process of the memory, that is, disables SREF WIN and invalidates a current self refresh command SREFc. In this case, a to-be-refreshed address corresponding to 2n+4 cannot be refreshed, and a count value of an internal refresh address counter is an odd number 2n+3. It may be learned from the foregoing description that, in this case, the abort signal RST further needs to adjust the count value of the internal refresh address counter to an even number with help of a related circuit. For the example of FIG. 3, the count value of the internal refresh address counter needs to be adjusted to a value such as 2n+2, 2n, or 2n-2.

For this, currently, the memory is provided with a counter structure. The counter structure is disposed in a bank to implement a function of a refresh address counter, and is further configured to adjust a count value to an even number in cooperation with the abort signal RST.

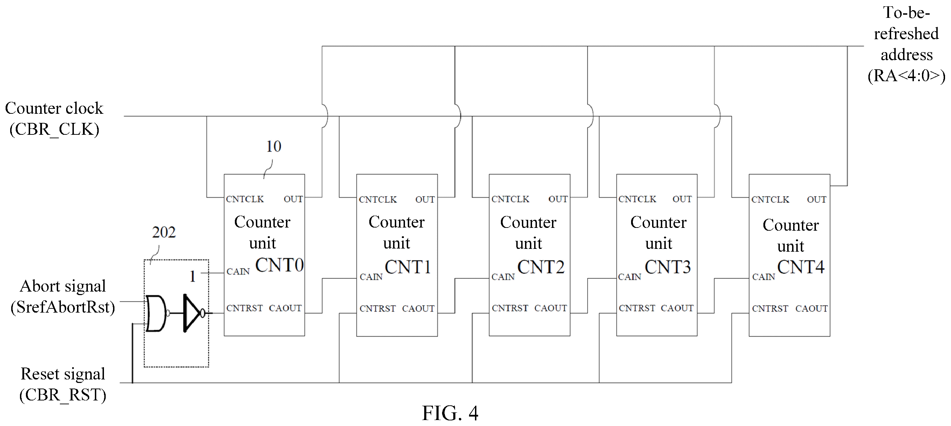

Specifically, referring to FIG. 4, FIG. 4 is a schematic structural diagram of a counter structure according to the present disclosure. The to-be-refreshed address is an n-bit binary signal. The counter structure includes n cascaded counter units 10, and each counter unit 10 includes the following: a clock terminal CNTCLK, configured to receive a counter clock CBR_CLK; a reset control terminal CNTRST, configured to receive a reset signal CBR_RST, the reset control terminal of the counter unit 10 at the first stage being further configured to receive an abort signal SrefAbortRst; a first output terminal OUT, configured to generate an address signal, n address signals generated by the n counter units 10 constituting a to-be-refreshed address RA<n:0>; and a second output terminal CAOUT, connected to a control terminal CAIN of the counter unit 10 at the next stage, and configured to generate a carry signal, a control terminal CAIN of the counter unit 10 at the first stage receiving a high level. The counter unit 10 is configured to toggle the address signal and the carry signal based on the counter clock CBR_CLK when a signal input by a control terminal is valid.

It should be noted that, both the reset signal CBR_RST and the abort signal SrefAbortRst can be received by the counter unit 10 at the first stage through an OR logic circuit.

Specifically, one input terminal of the OR logic circuit is configured to receive the reset signal CBR_RST, the other input terminal thereof is configured to receive the abort signal SrefAbortRst, and an output terminal thereof is connected to the reset control terminal CNTRST of the counter unit 10 at the first stage . It should be noted that, in the example of FIG. 4, the OR logic circuit is implemented based on a NOR gate and an inverter that are cascaded. In another example, alternatively, the OR logic circuit may be formed based directly on an OR gate or multiple other cascaded gate circuits.

It should be further noted that, in FIG. 4, a counter structure including five cascaded counter units 10 is taken as an example for description. In this case, the counter structure generates a to-be-refreshed address RA<4:0>. A person skilled in the art may configure a corresponding number of counter units 10 based on a specific number of bits of the to-be-refreshed address RA<n:0>.

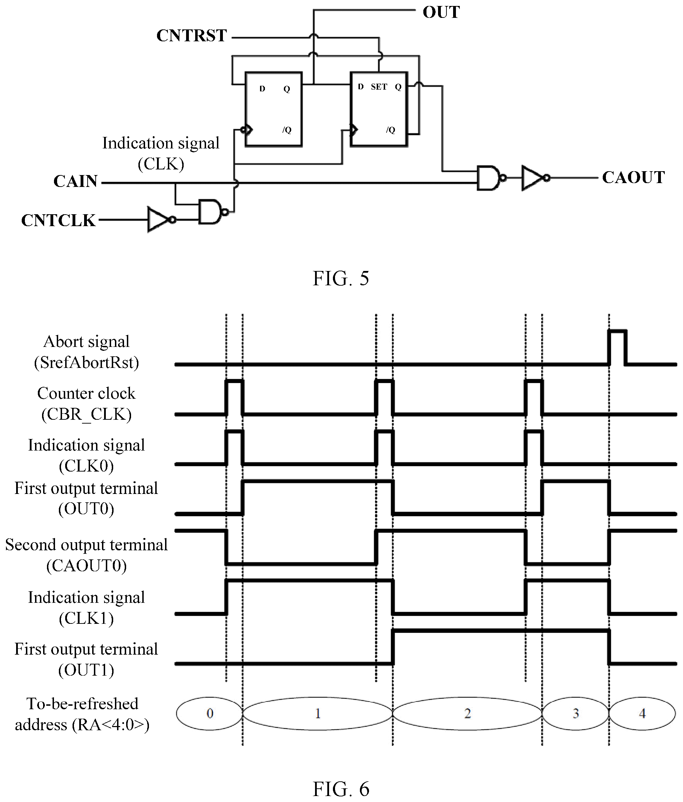

Referring to FIG. 5, FIG. 5 is a schematic structural diagram of each counter unit in the counter structure shown in FIG. 4 according to the present disclosure. Each counter unit 10 includes the following: a first inverter, an input terminal being connected to the clock terminal CNTCLK of the counter unit 10 to receive the counter clock CBR_CLK; a NAND gate, a first input terminal being connected to an output terminal of the first inverter, and a second input terminal being connected to the control terminal CAIN of the counter unit 10; a first flip-flop, an inverted-clock terminal being connected to an output terminal of the NAND gate, and an output terminal Q being connected to the first output terminal OUT of the counter unit 10; and a second flip-flop, a clock terminal being connected to the output terminal of the NAND gate, an input terminal D being connected to the output terminal Q of the first flip-flop, and an inverted-output terminal /Q being connected to an input terminal D of the first flip-flop.

Referring to FIG. 5 in conjunction with FIG. 6, FIG. 6 is a schematic diagram of a counting principle of the counter structure shown in FIG. 4 and FIG. 5 according to the present disclosure. The control terminal CAIN of the counter unit 10 at the first stage receives a high level. In this case, the NAND gate may be considered as an inverter, and an indication signal CLKx output by the NAND gate may be considered as a signal, the same as the counter clock CBR_CLK, obtained after the counter clock CBR_CLK is phase-inverted through two stages. It should be noted that, for the indication signal CLKx, namely, CLK shown in FIG. 6, an indication signal in the counter unit 10 at the first stage is CLK0, an indication signal in the counter unit 10 at the second stage is CLK1, ..., and an indication signal in the counter unit 10 at the n+1 stage is CLKn.

Because the output terminal of the NAND gate is connected to the inverted-clock terminal of the first flip-flop, the inverted-clock terminal of the flip-flop is driven based on a falling edge, that is, the first flip-flop is driven based on a falling edge of the indication signal CLKx output by the NAND gate. Because the output terminal Q of the first flip-flop is connected to the input terminal of the second flip-flop, and the inverted-output terminal /Q of the second flip-flop is connected to the input terminal D of the first flip-flop, it may be considered that the first flip-flop and the second flip-flop control an output signal to toggle based on a valid signal of the clock terminal or the inverted-clock terminal. Referring to FIG. 5 and FIG. 6, the first flip-flop in the counter unit 10 at the first stage toggles an address signal OUT0 based on the indication signal CLK0 to form one of the bits of the to-be-refreshed address RA<n:0>. It should be noted that data output by the counter unit 10 at the first stage to the first output terminal OUT is an address signal OUT0, data output by the counter unit 10 at the second stage to the first output terminal OUT is an address signal OUT1, ..., and data output by the counter unit 10 at the n+1 stage to the first output terminal OUT is an address signal OUTn.

For the second flip-flop, the clock terminal of the second flip-flop is connected to the clock terminal CNTCLK of the counter unit 10 to receive the counter clock CBR_CLK. The clock terminal of the flip-flop is driven based on a rising edge, that is, it may be considered that the second flip-flop toggles an output signal based on a rising edge of the counter clock CBR_CLK. Referring to FIG. 5 and FIG. 6, the second flip-flop in the counter unit 10 at the first stage toggles an output signal based on the rising edge of the counter clock CBR_CLK to generate a carry signal CAOUT0. It should be noted that, a carry signal output by the counter unit 10 at the first stage is CAOUT0, a carry signal output by the counter unit 10 at the second stage is CAOUT1, ..., and a carry signal output by the counter unit 10 at the n+1 stage is CAOUTn.

For a counter unit 10 not at the first stage, the control terminal CAIN of the counter unit 10 is connected to the second output terminal CAOUT of the counter unit 10 at the previous stage to receive a carry signal CAOUTx. Based on working principles of the first inverter and the NAND gate, as shown in FIG. 6, the NAND gate in the counter unit 10 at the second stage generates the indication signal CLK1 based on the carry signal CAOUT0 generated by the counter unit 10 at the first stage and the counter clock CBR_CLK. The first flip-flop in the counter unit 10 at the second stage toggles the address signal OUT1 based on a falling edge of the indication signal CLK1.

For each counter unit 10, a set terminal SET of the second flip-flop is connected to the reset control terminal CNTRST. The reset control terminal CNTRST of the counter unit 10 at the first stage is configured to receive the reset signal CBR_RST and the abort signal SrefAbortRst, and the reset control terminal CNTRST of another counter unit 10 is configured to receive only the reset signal CBR_RST. When the abort signal SrefAbortRst is valid, the carry signal CAOUT0 output by the second flip-flop in the counter unit 10 at the first stage is set to 1. In a process of setting the carry signal CAOUT0 output by the second flip-flop in the counter unit 10 at the first stage to 1, because the indication signal CLK0 is at a low level, inverted output data of the second flip-flop is sampled by the first flip-flop, and the output address signal OUT0 is set to 0 by the first flip-flop, thereby resetting the lowest bit of the to-be-refreshed address to 0. However, in this process, because the carry signal CAOUT0 generated by the counter unit 10 at the first stage is 1, a falling edge appears in the indication signal CLK1 generated by the NAND gate in the counter unit 10 at the second stage, and the falling edge of the indication signal CLK1 instructs the first flip-flop to toggle data, so that the counter structure counts forward, that is, the counter structure counts based on the abort signal SrefAbortRst, and the counter address is incremented by 1. As shown in FIG. 6, in a process of refreshing a to-be-refreshed address 3, the abort signal SrefAbortRst is valid, and a to-be-refreshed address count advances to 4. Then, a subsequent refresh process starts with the to-be-refreshed address 4, missing refresh of the to-be-refreshed address 3.

It can be learned from this description that, although the counter structure in the current memory can adjust a count value to an even number in coordination with the abort signal RST, the adjusted count value causes the memory to miss refresh of a certain address, and may cause an abnormality to data stored in the memory.

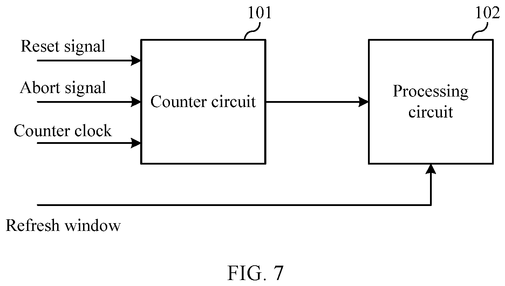

For this, an embodiment of the present disclosure provides a refresh control structure. Referring to FIG. 7, FIG. 7 is a schematic structural diagram of a refresh control structure according to an embodiment of the present disclosure. The refresh control structure is disposed in a bank, to at least improve self refresh accuracy of the memory. The refresh control structure includes a processing circuit 102 and a counter circuit 101. The processing circuit 102 is configured to refresh a to-be-refreshed address based on a refresh window. The counter circuit 101 is configured to generate the to-be-refreshed address, and control, based on a counter clock, the generated to-be-refreshed address to be incremented by 1. In addition, the counter circuit 101 is further configured to reset the lowest bit of the to-be-refreshed address based on an abort signal, and in a process of resetting the lowest bit of the to-be-refreshed address, maintain the second lowest bit of the to-be-refreshed address unchanged.

According to the refresh control structure provided in this embodiment, in the process in which the counter circuit 101 resets the lowest bit of the to-be-refreshed address, the second lowest bit of the to-be-refreshed address remains unchanged. A counting process for the to-be-refreshed address caused by a carry signal is avoided in the process of resetting the lowest bit, thereby further avoiding a possible occurrence of a missing refresh problem on the memory.

It should be noted that the refresh control structure shown in FIG. 7 is further configured to receive a reset signal, and the reset signal is configured to reset or set a count value of the counter circuit 101, thereby resetting, based on the reset signal, the to-be-refreshed address generated by the counter circuit 101.

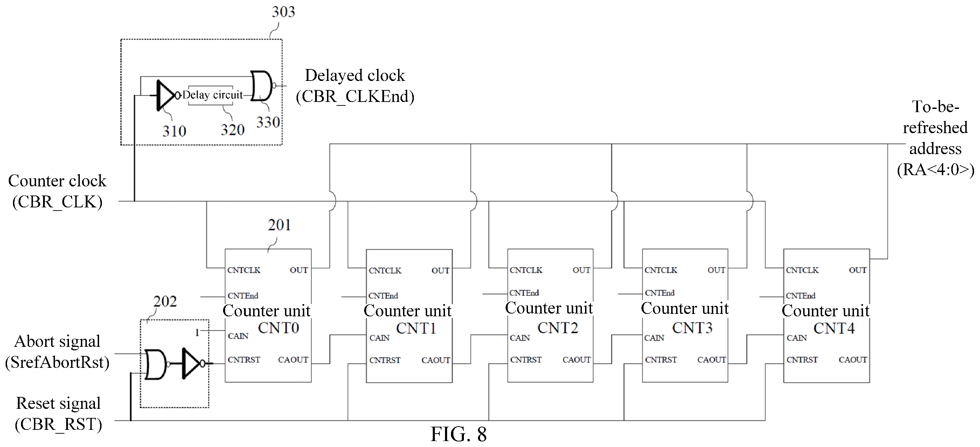

Specifically, referring to FIG. 8, FIG. 8 is a schematic structural diagram of a counter circuit according to an embodiment of the present disclosure. The to-be-refreshed address is an n-bit binary signal. The counter circuit 101 includes n cascaded counter units 201, and each counter unit 201 includes the following: a first clock terminal CNTCLK, configured to receive a counter clock CBR_CLK; a second clock terminal CNTEnd, configured to receive a delayed clock CBR_CLKEnd, the delayed clock CBR_CLKEnd being a delayed signal of the counter clock CBR_CLK; a reset control terminal CNTRST, configured to receive a reset signal CBR_RST, the reset control terminal of the counter unit 201 at the first stage being further configured to receive an abort signal SrefAbortRst; a first output terminal OUT, configured to generate an address signal, n address signals generated by the n counter units 201 constituting the to-be-refreshed address RA<n:0>; and a second output terminal CAOUT, connected to a control terminal CAIN of the counter unit 201 at the next stage, and configured to generate a carry signal, a control terminal CAIN of the counter unit 201 at the first stage receiving a high level. The counter unit 201 is configured to toggle the address signal based on the delayed clock CBR_CLKEnd and toggle the carry signal based on the counter clock CBR_CLK when a signal input by a control terminal is valid.

It should be noted that, for the counter circuit 101, both the reset signal CBR_RST and the abort signal SrefAbortRst may be received through an OR logic circuit 202. Specifically, one input terminal of the OR logic circuit 202 is configured to receive the reset signal CBR_RST, the other input terminal thereof is configured to receive the abort signal SrefAbortRst, and an output terminal thereof is connected to the reset control terminal CNTRST of the counter unit 201 at the first stage. It should be noted that, in the example of FIG. 8, the OR logic circuit 202 is implemented based on a NOR gate and an inverter that are cascaded. In another example, alternatively, the OR logic circuit may be formed based directly on an OR gate or multiple other cascaded gate circuits.

It should be further noted that, in the example of FIG. 8, the counter circuit 101 including five cascaded counter units 201 is taken as an example for description. In this case, a to-be-refreshed address RA<4:0> is generated. FIG. 8 does not constitute a limitation on the number of counter units 201 in the counter circuit 101 in this embodiment. A person skilled in the art may configure a corresponding number of counter units 201 based on a specific number of bits of the to-be-refreshed address RA<n:0>.

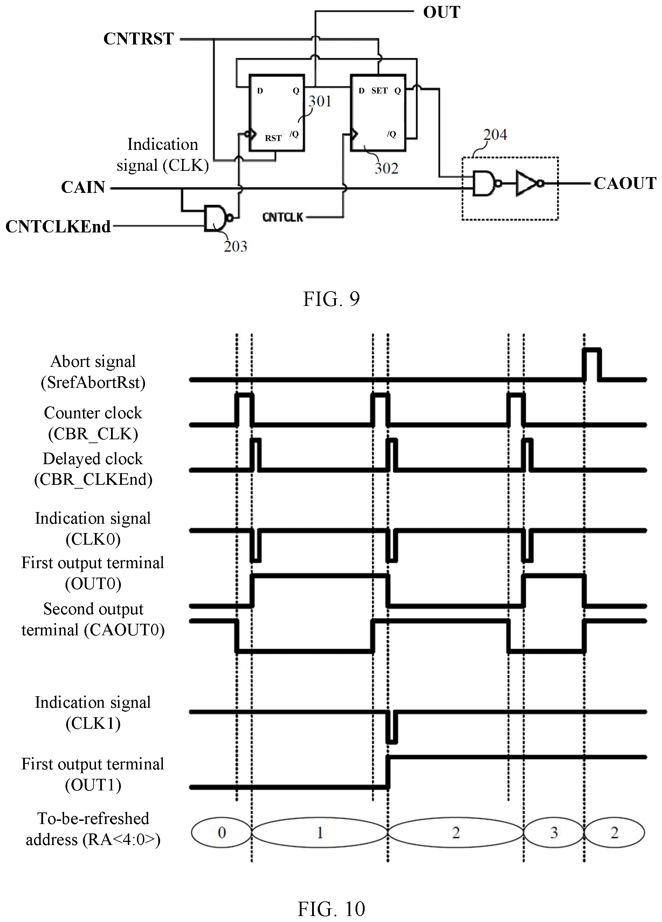

Referring to FIG. 9, FIG. 9 is a schematic structural diagram of each counter unit in the counter circuit shown in FIG. 8 according to an embodiment of the present disclosure. Each counter unit 201 includes a NAND logic circuit 203, a first flip-flop 301, and a second flip-flop 302. A first input terminal of the NAND logic circuit 203 is connected to the control terminal CAIN of the counter unit 201, and a second input terminal thereof is configured to receive the delayed clock CNTCLKEnd. An inverted-clock terminal of the first flip-flop 301 is connected to an output terminal of the NAND logic circuit 203, an output terminal Q thereof is connected to the first output terminal OUT of the counter unit 201, and a reset terminal RST thereof is connected to the reset control terminal CNTRST of the counter unit 201. A clock terminal of the second flip-flop 302 is configured to receive the counter clock CBR_CLK, an input terminal D thereof is connected to the output terminal Q of the first flip-flop 301, an inverted-output terminal /Q is connected to an input terminal D of the first flip-flop 301, and a set terminal SET is connected to the reset control terminal CNTRST of the counter unit 201.

In an example, the NAND logic circuit 203 is implemented by a NAND gate. In another example, the NAND logic circuit may alternatively be implemented by cascading an AND gate and an inverter, or implemented by a combination of other logic gate circuits.

Referring to FIG. 9 in conjunction with FIG. 10, FIG. 10 is a schematic diagram of a counting principle of the counter circuit shown in FIG. 8 and FIG. 9 according to an embodiment of the present disclosure. The control terminal CAIN of the counter unit 201 at the first stage receives a high level. In this case, the NAND logic circuit 203 may be considered as an inverter, and the indication signal CLKx output by the NAND logic circuit 203 and the delayed clock CBR_CLKEnd are inverted signals to each other. It should be noted that, for the indication signal CLKx, namely, CLK shown in FIG. 9, an indication signal in the counter unit 201 at the first stage is CLK0, an indication signal in the counter unit 201 at the second stage is CLK1, ..., and an indication signal in the counter unit 201 at the n+1 stage is CLKn.

Because the output terminal of the NAND logic circuit 203 is connected to the inverted-clock terminal of the first flip-flop 301, the inverted-clock terminal of the flip-flop is driven based on a falling edge, that is, the first flip-flop 301 is driven based on a falling edge of the indication signal CLKx output by the NAND logic circuit 203. In addition, the indication signal CLKx output by the NAND logic circuit 203 and the delayed clock CBR_CLKEnd are inverted signals to each other, and it may be considered that the first flip-flop 301 is driven based on a rising edge of the delayed clock CBR_CLKEnd. Because the output terminal Q of the first flip-flop 301 is connected to the input terminal of the second flip-flop 302, and the inverted-output terminal /Q of the second flip-flop 302 is connected to the input terminal D of the first flip-flop 301, it may be considered that the first flip-flop 301 and the second flip-flop 302 control an output signal to toggle based on a valid signal of the clock terminal or the inverted-clock terminal. Referring to FIG. 9 and FIG. 10, the first flip-flop 301 in the counter unit 201 at the first stage toggles an address signal OUT0 based on a falling edge of the indication signal CLK0 to form one of the bits of the to-be-refreshed address RA<n:0>. It should be noted that data output by the counter unit 201 at the first stage to the first output terminal OUT is OUT0, data output by the counter unit 201 at the second stage to the first output terminal OUT is OUT1, ..., and data output by the counter unit 201 at the n+1 stage to the first output terminal OUT is OUTn.

For the second flip-flop 302, the clock terminal of the second flip-flop 302 is connected to the first clock terminal CNTCLK to receive the counter clock CBR_CLK. The clock terminal of the flip-flop is driven based on a rising edge, that is, it may be considered that the second flip-flop 302 toggles an output signal CAOUTx based on a rising edge of the counter clock CBR_CLK. Referring to FIG. 9 and FIG. 10, the second flip-flop 302 in the counter unit 201 at the first stage toggles an output signal based on the rising edge of the counter clock CBR_CLK to generate a carry signal CAOUT0. It should be noted that, a carry signal output by the counter unit 201 at the first stage is CAOUT0, a carry signal output by the counter unit 201 at the second stage is CAOUT1, ..., and a carry signal output by the counter unit 201 at the n+1 stage is CAOUTn.

For a counter unit 201 not at the first stage, the control terminal CAIN of the counter unit 201 is connected to the second output terminal CAOUT of the counter unit 201 at the previous stage to receive the carry signal CAOUTx. Based on a working principle of the NAND logic circuit 203, when a carry signal generated by the counter unit 201 at the previous stage is at a high level, an inverted pulse of the delayed clock CNTCLKEnd is correspondingly generated. As shown in FIG. 10, the NAND logic circuit 203 in the counter unit 201 at the second stage generates the indication signal CLK1 based on the carry signal CAOUT0 generated by the counter unit 201 at the first stage and the delayed clock CNTCLKEnd. The first flip-flop 301 in the counter unit 201 at the second stage toggles an address signal OUT1 based on a falling edge of the indication signal CLK1.

For each counter unit 201, the set terminal SET of the first flip-flop 301 and a set terminal SET of the second flip-flop 302 are connected to the reset control terminal CNTRST. The reset control terminal CNTRST of the counter unit 201 at the first stage is configured to receive the reset signal CBR_RST and the abort signal SrefAbortRst, and the reset control terminal CNTRST of another counter unit 201 is configured to receive only the reset signal CBR_RST. When the abort signal SrefAbortRst is valid, the address signal OUT0 output by the first flip-flop 301 in the counter unit 201 at the first stage is reset to 0, and the carry signal CAOUT0 output by the second flip-flop 302 in the counter unit 201 at the first stage is set to 1. However, due to structure settings of the counter unit 201, a value of the indication signal CLKx in a subsequent counter unit 201 is not affected by a carry signal set to 1. Referring to FIG. 10, after the output carry signal CAOUT0 is set to 1 by the counter unit 201 at the first stage based on the abort signal SrefAbortRst, the indication signal CLK1 in the counter unit 201 at the second stage does not transition, and the counter circuit 101 does not continue with the counting, but only resets the lowest bit. That is, in a process of refreshing a to-be-refreshed address 3, the abort signal SrefAbortRst is valid, and the to-be-refreshed address is reset to 2. Then, a subsequent refresh process starts with the to-be-refreshed address 2, and the refresh process proceeds, without missing refresh.

It should be noted that, compared to the counter structure, the counter circuit 101 in this embodiment introduces a delay to an output signal of the first flip-flop 301. This is because the first flip-flop 301 is driven based on the delayed clock signal CNTCLKEnd, while the second flip-flop 302 is driven based on the counter clock CBR_CLK. Consequently, there is a specific delay between the output data of the first flip-flop 301 and the output data of the second flip-flop 302, which are normally inverted with respect to each other.

In some embodiments, referring to FIG. 9, the counter unit 201 further includes an AND logic circuit 204, a first input terminal being connected to an output terminal Q of the second flip-flop 302, a second input terminal being connected to the control terminal CAIN of the counter unit 201, and an output terminal being connected to the second output terminal CAOUT of the counter unit 201, so that the carry signal output by the counter unit 201 is controlled by an input signal of the control terminal. In an example, the AND logic circuit 204 is implemented by connecting a NAND gate and an inverter in series. In another example, the AND logic circuit may alternatively be implemented based on an AND gate, or implemented by a combination of other logic gate circuits.

In some embodiments, the refresh control structure further includes a delay unit, configured to generate the delayed clock CBR_CLKEnd based on the counter clock CBR_CLK.

In an example, referring to FIG. 8, the delay unit 303 includes the following: a NOT logic circuit 310, an input terminal being configured to receive the counter clock CBR_CLK; a delay circuit 320, an input terminal being connected to an output terminal of the NOT logic circuit 310; and a NOR logic circuit 330, a first input terminal being configured to receive the counter clock CBR_CLK, a second input terminal being connected to an output terminal of the delay circuit 320, and an output terminal being configured to output the delayed clock CBR_CLKEnd.

In another example, the delay unit includes a delay circuit, an input terminal of the delay circuit being configured to receive the counter clock CBR_CLK, and an output terminal thereof being configured to output the delayed clock CBR_CLKEnd. The counter clock CBR_CLK is directly delayed to generate and output the delayed clock CBR_CLKEnd.

According to the refresh control structure provided in this embodiment, in the process in which the counter circuit resets the lowest bit of the to-be-refreshed address, the second lowest bit of the to-be-refreshed address remains unchanged. A counting process for the to-be-refreshed address caused by a carry signal is avoided in the process of resetting the lowest bit, thereby further avoiding a possible occurrence of a missing refresh problem on the memory.

It should be noted that the features disclosed in the refresh control structure provided in the foregoing embodiment may be randomly combined when there is no conflict, to obtain a new refresh control structure embodiment.

Another embodiment of the present disclosure provides a refresh control method, to at least improve self refresh accuracy of a memory.

Specifically, the refresh control method includes the following: a to-be-refreshed address is obtained, and the to-be-refreshed address is refreshed based on a refresh window; the to-be-refreshed address is controlled, based on a counter clock, to be incremented by 1 after the refresh is complete, an even number of refresh windows being opened based on the same refresh command; and the to-be-refreshed address is adjusted based on the refresh control structure provided based on the foregoing embodiments in a refresh execution process if an abort signal is received.

Referring to FIG. 9 in conjunction with FIG. 10, the control terminal CAIN of the counter unit 201 at the first stage receives a high level. In this case, the NAND logic circuit 203 may be considered as an inverter, and the indication signal CLKx output by the NAND logic circuit 203 and the delayed clock CBR_CLKEnd are inverted signals to each other. It should be noted that, for the indication signal CLKx, namely, CLK shown in FIG. 9, an indication signal in the counter unit 201 at the first stage is CLK0, an indication signal in the counter unit 201 at the second stage is CLK1, ..., and an indication signal in the counter unit 201 at the n+1 stage is CLKn.

Because the output terminal of the NAND logic circuit 203 is connected to the inverted-clock terminal of the first flip-flop 301, the inverted-clock terminal of the flip-flop is driven based on a falling edge, that is, the first flip-flop 301 is driven based on a falling edge of the indication signal CLKx output by the NAND logic circuit 203. In addition, the indication signal CLKx output by the NAND logic circuit 203 and the delayed clock CBR_CLKEnd are inverted signals to each other, and it may be considered that the first flip-flop 301 is driven based on a rising edge of the delayed clock CBR_CLKEnd. Because the output terminal Q of the first flip-flop 301 is connected to the input terminal of the second flip-flop 302, and the inverted-output terminal /Q of the second flip-flop 302 is connected to the input terminal D of the first flip-flop 301, it may be considered that the first flip-flop 301 and the second flip-flop 302 control an output signal to toggle based on a valid signal of the clock terminal or the inverted-clock terminal. Referring to FIG. 9 and FIG. 10, the first flip-flop 301 in the counter unit 201 at the first stage toggles an address signal OUT0 based on a falling edge of the indication signal CLK0 to form one of the bits of the to-be-refreshed address RA<n:0>. It should be noted that data output by the counter unit 201 at the first stage to the first output terminal OUT is OUT0, data output by the counter unit 201 at the second stage to the first output terminal OUT is OUT1, ..., and data output by the counter unit 201 at the n+1 stage to the first output terminal OUT is OUTn.

For the second flip-flop 302, the clock terminal of the second flip-flop 302 is connected to the first clock terminal CNTCLK to receive the counter clock CBR_CLK. The clock terminal of the flip-flop is driven based on a rising edge, that is, it may be considered that the second flip-flop 302 toggles an output signal CAOUTx based on a rising edge of the counter clock CBR_CLK. Referring to FIG. 9 and FIG. 10, the second flip-flop 302 in the counter unit 201 at the first stage toggles an output signal based on the rising edge of the counter clock CBR_CLK to generate a carry signal CAOUT0. It should be noted that, a carry signal output by the counter unit 201 at the first stage is CAOUT0, a carry signal output by the counter unit 201 at the second stage is CAOUT1, ..., and a carry signal output by the counter unit 201 at the n+1 stage is CAOUTn.

For a counter unit 201 not at the first stage, the control terminal CAIN of the counter unit 201 is connected to the second output terminal CAOUT of the counter unit 201 at the previous stage to receive the carry signal CAOUTx. Based on a working principle of the NAND logic circuit 203, when a carry signal generated by the counter unit 201 at the previous stage is at a high level, an inverted pulse of the delayed clock CNTCLKEnd is correspondingly generated. As shown in FIG. 10, the NAND logic circuit 203 in the counter unit 201 at the second stage generates the indication signal CLK1 based on the carry signal CAOUT0 generated by the counter unit 201 at the first stage and the delayed clock CNTCLKEnd. The first flip-flop 301 in the counter unit 201 at the second stage toggles an address signal OUT1 based on a falling edge of the indication signal CLK1.

For each counter unit 201, the set terminal SET of the first flip-flop 301 and a set terminal SET of the second flip-flop 302 are connected to the reset control terminal CNTRST. The reset control terminal CNTRST of the counter unit 201 at the first stage is configured to receive the reset signal CBR_RST and the abort signal SrefAbortRst, and the reset control terminal CNTRST of another counter unit 201 is configured to receive only the reset signal CBR_RST. When the abort signal SrefAbortRst is valid, the address signal OUT0 output by the first flip-flop 301 in the counter unit 201 at the first stage is reset to 0, and the carry signal CAOUT0 output by the second flip-flop 302 in the counter unit 201 at the first stage is set to 1. However, due to structure settings of the counter unit 201, a value of the indication signal CLKx in a subsequent counter unit 201 is not affected by a carry signal set to 1. Referring to FIG. 10, after the output carry signal CAOUT0 is set to 1 by the counter unit 201 at the first stage based on the abort signal SrefAbortRst, the indication signal CLK1 in the counter unit 201 at the second stage does not transition, and the counter circuit 101 does not continue with the counting, but only resets the lowest bit. That is, in a process of refreshing a to-be-refreshed address 3, the abort signal SrefAbortRst is valid, and the to-be-refreshed address is reset to 2. Then, a subsequent refresh process starts with the to-be-refreshed address 2, and the refresh process proceeds, without missing refresh.

It is easy to find that this embodiment may be implemented in cooperation with the refresh control structure provided in the previous embodiment. The related technical details described in the previous embodiment are still effective in this embodiment. To reduce repetition, the details are not described herein again.

Still another embodiment of the present disclosure further provides a memory. The memory is provided with multiple banks, and each of the multiple banks includes the refresh control structure provided in the foregoing embodiments, and performs a self refresh function based on the refresh control structure.

In a process in which a counter circuit resets the lowest bit of a to-be-refreshed address, the second lowest bit of the to-be-refreshed address remains unchanged. A counting process for the to-be-refreshed address caused by a carry signal is avoided in the process of resetting the lowest bit, thereby further avoiding a possible occurrence of a missing refresh problem on the memory.

It should be noted that, the memory may be a storage cell or apparatus based on a semiconductor apparatus or component. For example, a memory apparatus may be a volatile memory, e.g., a dynamic random access memory (DRAM), a synchronous dynamic random access memory (SDRAM), a double data rate synchronous dynamic random access memory (DDR SDRAM), a low power double data rate synchronous dynamic random access memory (LPDDR SDRAM), a graphics double data rate synchronous dynamic random access memory (GDDR SDRAM), a double data rate 2 synchronous dynamic random access memory (DDR2 SDRAM), a double data rate 3 synchronous dynamic random access memory (DDR3 SDRAM), a double data rate 4 synchronous dynamic random access memory (DDR4 SDRAM), or a thyristor random access memory (TRAM); or may be a non-volatile memory, e.g., a phase-change random access memory (PRAM), a magnetic random access memory (MRAM), or a resistive random access memory (RRAM).

A person of ordinary skill in the art may understand that the foregoing embodiments are specific embodiments for implementing the present disclosure. In actual application, various changes may be made to the forms and details of the embodiments without departing from the spirit and scope of the present disclosure.

## Claims

1. A refresh control structure, disposed in a bank, comprising:
a processing circuit (102), configured to refresh a to-be-refreshed address based on a refresh window; and
a counter circuit (101), configured to generate the to-be-refreshed address, and control, based on a counter clock, the generated to-be-refreshed address to be incremented by 1;
the counter circuit being further configured to reset a lowest bit of the to-be-refreshed address based on an abort signal, and in a process of resetting the lowest bit of the to-be-refreshed address, maintain a second lowest bit of the to-be-refreshed address unchanged.

2. The refresh control structure according to claim 1, wherein the to-be-refreshed address is an n-bit binary signal, the counter circuit comprises n cascaded counter units (201), and each counter unit comprises the following:
a first clock terminal (CNTCLK), configured to receive the counter clock;
a second clock terminal (CNTEnd), configured to receive a delayed clock, the delayed clock being a delayed signal of the counter clock;
a reset control terminal (CNTRST), configured to receive a reset signal, the reset control terminal of the counter unit at the first stage being further configured to receive the abort signal;
a first output terminal (OUT), configured to generate an address signal, n address signals generated by the n counter units constituting the to-be-refreshed address; and
a second output terminal (CAOUT), connected to a control terminal of the counter unit at a next stage, and configured to generate a carry signal, a control terminal of the counter unit at the first stage receiving a high level;
the counter unit being configured to toggle the address signal based on the delayed clock and toggle the carry signal based on the counter clock when a signal input by a control terminal is valid.

3. The refresh control structure according to claim 2, wherein the counter unit comprises the following:
a NAND logic circuit (203), a first input terminal being connected to the control terminal, and a second input terminal being configured to receive the delayed clock;
a first flip-flop (301), an inverted-clock terminal being connected to an output terminal of the NAND logic circuit, an output terminal being connected to the first output terminal, and a reset terminal being connected to the reset control terminal; and
a second flip-flop (302), a clock terminal being configured to receive the counter clock, an input terminal being connected to the output terminal of the first flip-flop, an inverted-output terminal being connected to an input terminal of the first flip-flop, and a set terminal being connected to the reset control terminal.

4. The refresh control structure according to claim 3, wherein the counter unit further comprises an AND logic circuit (204), a first input terminal being connected to an output terminal of the second flip-flop, a second input terminal being connected to the control terminal, and an output terminal being connected to the second output terminal.

5. The refresh control structure according to claim 3, further comprising a delay unit (303), configured to generate the delayed clock based on the counter clock.

6. The refresh control structure according to claim 5, wherein the delay unit comprises the following:
a NOT logic circuit (310), an input terminal being configured to receive the counter clock;
a delay circuit (320), an input terminal being connected to an output terminal of the NOT logic circuit; and
a NOR logic circuit (330), a first input terminal being configured to receive the counter clock, a second input terminal being connected to an output terminal of the delay circuit, and an output terminal being configured to output the delayed clock.

7. The refresh control structure according to claim 5, wherein the delay unit comprises a delay circuit, an input terminal being configured to receive the counter clock, and an output terminal being configured to output the delayed clock.

8. The refresh control structure according to claim 1, wherein the counter circuit is configured to reset the to-be-refreshed address based on a reset signal.

9. A refresh control method, applied to a self refresh mode of a memory, comprising:
obtaining a to-be-refreshed address, and refreshing the to-be-refreshed address based on a refresh window;
controlling, based on a counter clock, the to-be-refreshed address to be incremented by 1 after the refresh is complete, an even number of refresh windows being opened based on the same refresh command; and
adjusting the to-be-refreshed address based on the refresh control structure according to any one of claims 1 to 8 in a refresh execution process if an abort signal is received.

10. A memory, provided with a plurality of banks, each of the plurality of banks comprising the refresh control structure according to any one of claims 1 to 8, and performing a self refresh function based on the refresh control structure.
